# FASCICULE DE BREVET EUROPEEN

(11) **EP 0 997 940 B1**
(45) Date de publication et mention de la délivrance du brevet: **08.02.2006**
(21) Numéro de dépôt: 99402532.8
(22) Date de dépôt: 14.10.1999
(51) Int. Cl.: H01L 23/492, H01L 23/52, H01L 23/482

(54) **Procédé de raccordement électrique de puces de transistor IGBT montées sur une plaquette de circuits intégrés**
Verfahren zur elektrischen Verbindung von auf einem IC montierten IGBTs
Process for electrically connecting IGBTs mounted on an IC

(30) Priorité: 30.10.1998 FR 9813690
(43) Date de publication de la demande: 03.05.2000
(73) Titulaire: ALSTOM Holdings, 92300 Levallois-Perret (FR)
(72) Inventeur: Changey, Nicolas, 52140 Montigny-le-Roi (FR); Petitbon, Alain, 78730 St Arnoult-en-Yvelines (FR); Crouzy, Sophie, 91440 Bures-sur-Yvette (FR); Ranchy, Eric, 94800 Villejuif (FR)
(74) Mandataire: Moncheny, Michel

(56) Documents cités:
- FR-A- 2 335 953
- US-A- 5 319 237
- US-A- 5 635 427
- PATENT ABSTRACTS OF JAPAN vol. 098, no. 006, 30 avril 1998 (1998-04-30) & JP 10 056131 A (DENSO CORP), 24 février 1998 (1998-02-24)

## Description

La présente invention est relative à un procédé de raccordement électrique de puces de transistor bipolaire à grille isolée (IGBT) montées sur une plaquette de circuits intégrés.

Un tel procédé consiste classiquement à souder des électrodes de collecteur, d'émetteur et de commande de grille sur des emplacements de connexion correspondants des puces.

Généralement, de telles électrodes sont constituées par des fils électriquement conducteurs assurant le raccordement électrique de la grille et de l'émetteur de chaque transistor à une source d'alimentation en énergie électrique, ces fils étant soudés, par ultrasons, sur les grilles et émetteurs.

Cette technique de raccordement des puces d'IGBT présente un certain nombre d'inconvénients.

Tout d'abord, la présence des fils, soudés sur l'une des grande face de la plaquette de circuits intégrés, interdit l'utilisation de moyens de refroidissement de la plaquette sur cette face, ce qui limite le nombre de puces qu'il est possible de monter que la plaquette, dans la mesure où une augmentation du nombre de puces s'accompagne d'une augmentation consécutive du courant d'alimentation des émetteurs et donc d'une augmentation de la quantité de chaleur dissipée.

Par ailleurs, dans la zone de soudure, les matériaux en contact présentent généralement des coefficients de dilatation différents, ce qui engendre des contraintes mécaniques non négligeables pouvant provoquer une cassure des électrodes.

Il est connu notamment par le document US-A-5 319 237, un procédé de raccordement d'une puce de transistor de puissance à une plaque, selon le préambule de la revendication 1.

Le but de l'invention est d'augmenter le nombre de puces qu'il est possible de monter sur une plaquette de circuit intégré.

Elle a donc pour objet un procédé de raccordement électrique de puces de transistor bipolaire à grille isolée monté sur une plaquette de circuit intégré, consistant à souder des électrodes de collecteur, d'émetteur et de commande de grilles sur des emplacements de connexion correspondants des puces, une partie au moins des électrodes d'émetteurs sont réalisées en une seule pièce sous la forme d'une plaque en matériau électriquement conducteur comportant, sur une de ses grandes faces, des parties en saillie délimitant des plots de connexion venant se souder sur les emplacements de connexion correspondants, caractérisé en ce qu'une électrode de commande de grille est réalisée en formant, dans ladite plaque, un plot en saillie associé à une piste d'alimentation et isolé du reste de la plaque, le plot venant se souder sur un emplacement de connexion correspondant.

Le procédé de raccordement électrique selon l'invention peut en outre comporter une ou plusieurs des caractéristiques suivantes prises isolément ou selon toutes les combinaisons techniquement possibles :
- les emplacements de connexion étant recouverts d'une couche métallique, notamment de l'aluminium, le procédé de raccordement électrique comporte les étapes suivantes, préalables au soudage des électrodes d'émetteurs :
   - désoxyder les emplacements de connexion des électrodes ;
   - déposer une couche de matériau anti-oxydant sur les emplacements de connexion désoxydés ,
   - déposer de la brasure sur les emplacements de connexion ;
   - déposer ladite plaque sur la plaquette de circuits intégrés de manière à appliquer les parties en saillie sur les emplacements de connexion ; et
   - placer la plaque et la plaquette dans un four de fusion ;
- le matériau anti-oxydant est choisi parmi le nickel, le chrome, l'or, ou un alliage de ces matériaux ;
- l'étape de désoxydation consiste à traiter les plaquettes par de l'acide nitrique ;
- l'électrode de commande de grille est réalisée au cours de la réalisation des électrodes d'émetteurs ;
- ladite plaque étant réalisée en un métal anodisé, notamment de l'aluminium, la réalisation de l'électrode de commande de grille comporte les étapes consistant à :

- former par métallisation une couche électriquement conductrice recouvrant la surface anodisée du plot formant électrode de commande de grille ;
   - former la piste d'alimentation par métallisation de la surface anodisée de la plaque ;
   - enterrer la piste métallisée ; et
   - déposer sur les plots une couche de matériau anti-oxydant ;
- postérieurement à l'étape consistant à former la piste d'alimentation, on dépose sur cette dernière une couche métallique ;
- l'étape consistant à enterrer la piste métallisée consiste à anodiser cette dernière.

D'autres caractéristiques et avantages ressortiront de la description suivante, donnée uniquement à titre d'exemple, et faite en référence aux dessins annexés sur lesquels:
- la figure 1 est une vue schématiquement en perspective d'une plaquette de circuits intégrés dotée de transistors IGBT et d'une plaque délimitant des électrodes d'émetteur et de commande de grille ;
- la figure 2 est une vue en coupe selon le plan 2-2 de la plaque de la figure 1;
- les figures 3,4,5 et 6 sont des vues en coupe selon le plan 3-3 de la plaque de la figure 1, montrant les différentes étapes de réalisation de l'électrode de commande de grille et des électrodes d'émetteur.

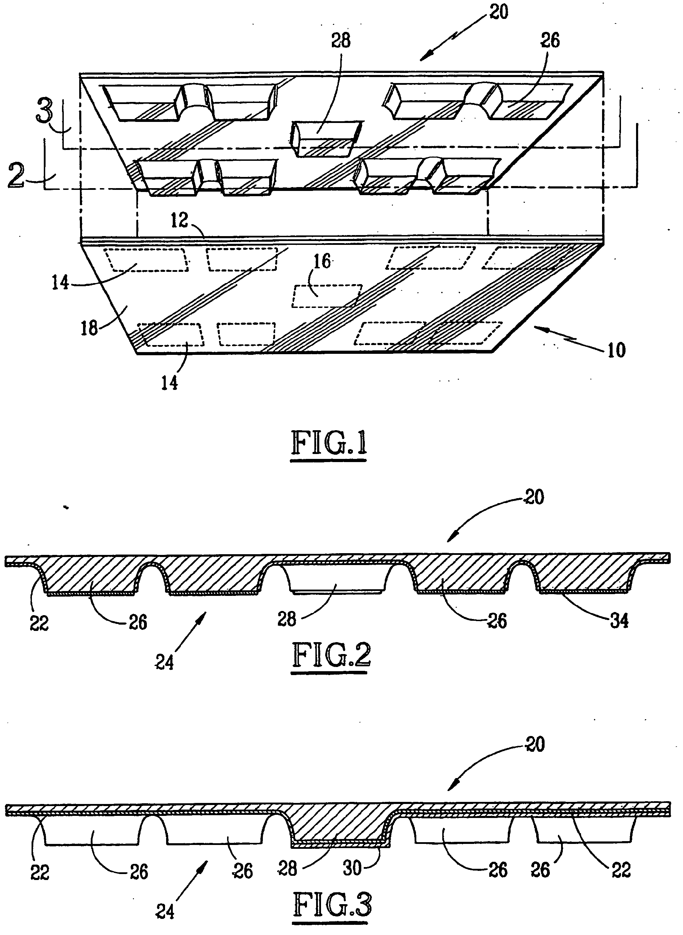

Sur la figure 1, on a représenté une plaquette de circuits intégrés, désignée par la référence numérique générale 10.

Elle est constituée par une plaquette de type classique, réalisée à partir d'une plaquette de silicium dans laquelle sont réalisées, par des techniques conventionnelles, des puces de transistor bipolaire à grille isolée, non représentées sur cette figure.

La plaquette 10 comporte une couche 12 de passivation, réalisée par exemple en polyamide, recouvrant la majeure partie de l'une des grandes faces de la plaquette 10 de manière à isoler le silicium sous-jacent.

Des zones d'interruption de la couche de passivation 12 délimitent un ensemble d'emplacements de connexions, tel que 14 pour le raccordement d'électrodes d'émetteur et un emplacement de connexion 16 pour le raccordement d'une électrode de commande de grille.

Comme cela est classique, les emplacements de connexion 14 et 16 sont recouverts d'une couche d'aluminium afin de protéger le silicium sous-jacent.

La grande face opposée de la plaquette 10 est pourvue d'une plaque métallique 18 constituant une électrode de collecteur.

En se référant également aux figures 2 et 3, les électrodes d'émetteurs et de commande de grille sont réalisées en une seule pièce 20 sous la forme d'une plaque en matériau électriquement conducteur, par exemple de l'aluminium.

Bien que cette plaque 20 puisse être réalisée à partir de tout autre type de matériau approprié pour l'utilisation envisagée, on considérera, dans la suite de la description, qu'elle est réalisée en aluminium anodisé de manière à la rendre insensible à l'oxydation, c'est-à-dire comportant une couche externe 22 d'alumine (figures 2 et 3).

La grande face 24 de la plaque 20, tournée vers la plaquette de circuit intégré 10, comporte un ensemble de plots de connexion, tels que 26 et 28, constituant les uns, 26, des électrodes d'émetteur, et l'autre, 28, une électrode de commande de grille, ces plots venant se souder sur les emplacements de connexion 14 et 16 ménagés dans la plaquette 10.

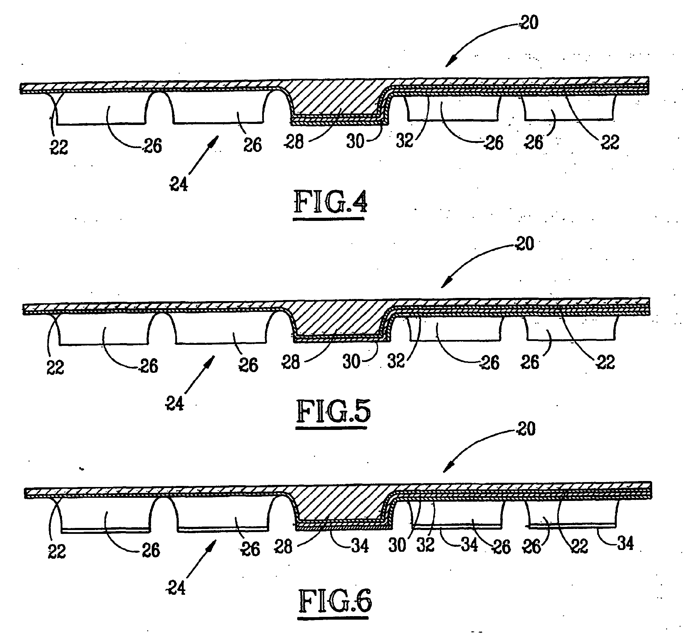

La description détaillée du procédé de réalisation de la plaque 20 va maintenant être faite en référence aux figures 3 à 6, sur lesquelles certains détails ont été exagérés par soucis de clarté.

En se référant tout d'abord à la figure 3, la première phase de réalisation consiste à former une plaque 20 en aluminium anodisé comportant, sur l'une de ses grandes faces 24, les plots 26 formant électrodes d'émetteur ainsi que le plot 28 formant électrode de commande de grille.

Comme mentionné précédemment, la plaque 20 est recouverte extérieurement d'une couche anodisée 22 de passivation en alumine de manière à la rendre inerte.

Cette couche 22 est ensuite métallisée localement de manière à constituer une piste 30 d'alimentation du plot 28 formant électrode de commande de grille, cette piste 30 recouvrant également ce plot 28.

Cette piste 30 est réalisée, par exemple, au moyen d'un laser excimère ou à ultraviolets capable de décomposer en surface l'alumine constitutive de la couche 22 pour reformer de l'aluminium, de manière à la rendre conductrice.

Lors de l'étape suivante, la piste 30 est anodisée de manière à l'enterrer pour l'isoler électriquement de l'extérieur.

On obtient alors la plaque 20 visible sur la figue 4 dans laquelle la piste 30 est recouverte d'une couche d'alumine 32.

En variante, dans le cas où la couche de passivation 22 n'est pas suffisamment épaisse pour subir, après formation de la piste 30, une anodisation tout en conservant une épaisseur suffisante d'aluminium dans la piste 30, préalablement à cette anodisation, on dépose une couche d'aluminium après l'étape de métallisation de la couche anodisée 22.

La plaque 20 subit ensuite une phase d'usinage des plots 26 et 28 de manière à mettre à nu l'aluminium sous-jacent. On obtient ainsi la plaque 20 représentée sur la figure 5, dans laquelle la couche de métal constitutive de la piste d'alimentation et recouvrant le plot 28 de commande de grille s'étend entre deux couches électriquement isolantes obtenues par anodisation..

L'étape finale consiste à recouvrir les plots 26 et 28 d'une couche 34 de matériau anti-oxydant capable en outre de permettre une soudure des plots sur les emplacements de connexion 14 et 16 (figure 1).

Par exemple, la couche de matériau anti-oxydant est constituée de nickel, de chrome, d'or, ou d'un alliage de ces métaux.

La plaque 20 ainsi obtenue, visible sur la figure 6, comporte un ensemble de plots 26 venus de matière, venant se souder sur les emplacements de connexion 14 correspondants en vue de l'alimentation de l'émetteur des puces d'IGBT, ainsi qu'un plot 28 constituant une électrode de commande de grille venant se souder sur l'emplacement de connexion 16 correspondant.

Ce plot 28 de commande de grille est isolé du reste de la plaque 20 par les couches 22 et 32 anodisées et est associé à une piste d'alimentation 30 elle-même isolée du reste de la plaque 20 par la deuxième couche 32 anodisée.

Pour procéder au soudage de la plaque 20 sur la plaquette 10 de circuits intégrés, il convient tout d'abord de désoxyder les emplacements de connexion 14 et 16, en trempant, par exemple, la plaquette 10 dans un bain d'acide nitrique, de préférence pendant 30 secondes.

On dépose sur les emplacements de connexion 14 et 16 désoxydés une couche de matériau anti-oxydant, par exemple le même matériau que celui utilisé pour rendre inoxydables les plots de connexion 26 et 28 de la plaque 20, c'est-à-dire du nickel, du chrome, de l'or ou un alliage de ces métaux.

On dépose ensuite des préformes de brasure sur les emplacements de connexion 14 et 16, par exemple en SnPbAg.

Après avoir positionné la plaque 20 sur la plaquette 10 de manière que les plots de connexion 26 et 28 de la plaque 20 soient appliqués contre les emplacements de connexion 14 et 16 correspondants de la plaquette de circuits intégrés 10, on place le tout dans un four en vue du soudage de l'ensemble.

On notera que, de préférence, la plaque métallique 18 constituant l'électrode de collecteur est soudée simultanément au soudage de la plaque 20 sur la plaquette de circuits intégrés 10.

On conçoit que l'invention qui vient d'être décrite, permet l'alimentation des émetteurs des puces d'IGBT, avec un courant relativement important, jusqu'à quelques centaines d'ampères, dans la mesure où les électrodes d'émetteur sont réalisées en une seule pièce, et ce tout en conservant la possibilité de prévoir une électrode de commande de grille intégrée à la plaque, tout en étant isolée du reste de celle-ci.

Dans la description de la plaque faite précédemment, on conçoit que la grande face de la plaque 20 opposée aux plots de raccordement 26 et 28 peut être dotée de moyens de refroidissement appropriés permettant ainsi une augmentation considérable du nombre de puces intégrées à la plaquette 10, dans la mesure où il est possible de faire circuler dans la plaque 20 un courant d'alimentation relativement important.

Par exemple, les moyens de refroidissement peuvent être configurés sous la forme de canaux dans lesquels circule un fluide de refroidissement, par exemple de l'eau desionisée.

On notera enfin que la plaque formant électrodes d'émetteur et de commande de grille peut être soudée sur des plaquettes de circuits intégrés disponibles dans le commerce.

L'invention n'est pas limitée aux modes de réalisation décrits. Il est en effet possible de réaliser les couches isolantes s'étendant de part et d'autre de la piste d'alimentation au moyen d'une technique différente, notamment par dépôt d'un revêtement électriquement isolant approprié.

## Revendications

1. Procédé de raccordement électrique de puces de transistor montées sur une plaquette (10) de circuits intégrés, consistant à souder des électrodes (26, 28) de collecteur, d'émetteur et de commande de grille sur des emplacements de connexion (14, 16) correspondants des puces, une partie au moins des électrodes (26) d'émetteurs sont réalisées en une seule pièce sous la forme d'une plaque (20) en matériau électriquement conducteur comportant, sur une de ses grandes faces, des parties en saillie délimitant des plots de connexion venant se souder sur les emplacements de connexion correspondants, **caractérisé en ce que** le transistor est un transistor bipolaire à grille isolée et **en ce qu'**une électrode (28) de commande de grille est réalisée en formant, dans ladite plaque, un plot en saillie associé à une piste d'alimentation et isolé du reste de la plaque, le plot venant se souder sur un emplacement de connexion correspondant.

2. Procédé selon la revendication 1, **caractérisé en ce que** les emplacements de connexion (14, 16) étant recouverts d'une couche métallique, notamment de l'aluminium, il comporte les étapes suivantes, préalables au soudage des électrodes d'émetteurs :
- désoxyder les emplacements de connexion (14, 16) des électrodes ;
- déposer une couche de matériau anti-oxydant sur les emplacements de connexion désoxydés ,
- déposer de la brasure sur les emplacements de connexion ;
- déposer ladite plaque (20) sur la plaquette (10) de circuits intégrés de manière à appliquer les parties en saillie sur les emplacements de connexion ; et
- placer la plaque et la plaquette dans un four de fusion.

3. Procédé selon la revendication 2, **caractérisé en ce que** le matériau anti-oxydant est choisi parmi le nickel, le chrome, l'or, ou un alliage de ces matériaux.

4. Procédé selon l'une des revendications 2 et 3, **caractérisé en ce que** l'étape de désoxydation consiste à traiter les plaquettes (10) par de l'acide nitrique.

5. Procédé selon l'une quelconque des revendications 1 à 4, **caractérisé en ce que** l'électrode (28) de commande de grille est réalisée au cours de la réalisation des électrodes (26) d'émetteurs.

6. Procédé selon la revendication 5, **caractérisé en ce que** ladite plaque étant réalisée en un métal anodisé, notamment de l'aluminium, la réalisation de l'électrode de commande de grille comporte les étapes consistant à :
- former par métallisation une couche (30) électriquement conductrice recouvrant la surface anodisée du plot formant électrode de commande de grille ;
- former la piste d'alimentation par métallisation de la surface anodisée de la plaque ;
- enterrer la piste métallisée ; et
- déposer sur les plots une couche de matériau anti-oxydant.

7. Procédé selon la revendication 6, **caractérisé en ce que**, postérieurement à l'étape consistant à former la piste d'alimentation, on dépose sur cette dernière une couche métallique.

8. Procédé selon l'une des revendications 6 et 7, **caractérisé en ce que** l'étape consistant à enterrer la piste métallisée consiste à anodiser cette dernière.

## Patentansprüche

1. Verfahren zur elektrischen Verbindung von Transistorchips, die auf einer integrierten Schaltkreisplatte (10) montiert sind, das daraus besteht, Kollektor-, Emitter- und Gittersteuerelektroden (26, 28) an den entsprechenden Verbindungsstellen (14, 16) der Chips zu verschweißen, wobei zumindest ein Teil der Emitterelektroden (26) aus einem einzigen Stück in Form einer Platte (20) aus elektrisch leitendem Material gebildet ist, welche auf einer ihrer großen Seiten vorspringende Bereiche aufweist, welche Verbindungsstifte begrenzen, die sich an den entsprechenden Verbindungsstellen verschweißen lassen, **dadurch gekennzeichnet, dass** der Transistor aus einem zweipoligen Transistor mit isoliertem Gitter besteht, und dass eine Gittersteuerelektrode (28) **dadurch** ausgebildet ist, dass in der Platte ein vorspringender Stift gebildet ist, der mit einer Versorgungsbahn verbunden und von dem Rest der Platte isoliert ist, wobei der Stift an einer entsprechenden Verbindungsstelle verschweißt wird.

2. Verfahren gemäß Anspruch 1, **dadurch gekennzeichnet, dass** wenn die Verbindungsstellen (14, 16) mit einer Metallschicht, insbesondere aus Aluminium überzogen sind, es die folgenden Schritte umfasst, die vor der Verschweißung der Emitterelektroden durchgeführt werden:
- Reduzierung der Verbindungsstellen (14, 16) der Elektroden;
- Aufbringen einer Schicht aus Oxidationsinhibitormaterial auf die reduzierten Verbindungsstellen,
- Aufbringen einer Lötfläche auf die Verbindungsstellen;
- Anordnung der Platte (20) auf der integrierten Schaltkreisplatte (10), so dass die vorspringenden Bereiche auf die Verbindungsstellen aufgelegt werden; und
- Anordnung der Platte und der Schaltkreisplatte in einem Schmelzofen.

3. Verfahren gemäß Anspruch 2, **dadurch gekennzeichnet, dass** das Oxidationsinhibitormaterial aus Nickel, Chrom, Gold oder einer Legierung aus diesen Materialien ausgewählt ist.

4. Verfahren gemäß einem der Ansprüche 2 und 3, **dadurch gekennzeichnet, dass** der Schritt der Reduzierung darin besteht, die Schaltkreisplatten (10) mit Salpetersäure zu behandeln.

5. Verfahren gemäß irgendeinem der Ansprüche 1 bis 4, **dadurch gekennzeichnet, dass** die Gittersteuerelektrode (28) im Verlauf der Herstellung der Emitterelektroden (26) hergestellt wird.

6. Verfahren gemäß Anspruch 5, **dadurch gekennzeichnet, dass** da die Platte aus anodisch oxidiertem Material, insbesondere Aluminium besteht, die Herstellung der Gittersteuerelektrode die Schritte umfasst, die bestehen aus:
- Ausbildung einer elektrisch leitenden Schicht (30), welche die anodisch oxidierte Oberfläche des die Gittersteuerelektrode bildenden Stiftes bedeckt;
- Ausbildung der Versorgungsbahn durch Metallisieren der anodisch oxidierten Oberfläche der Platte;
- Eingraben der metallisierten Bahn; und
- Aufbringen einer Schicht aus Oxidationsinhibitormaterial auf die Stifte;

7. Verfahren gemäß Anspruch 6, **dadurch gekennzeichnet, dass** nach dem Schritt, der daraus besteht die Versorgungsbahn auszubilden, auf dieser letzteren eine Metallschicht angeordnet wird.

8. Verfahren gemäß einem der Ansprüche 6 und 7, **dadurch gekennzeichnet, dass** der Schritt, der daraus besteht die metallisierte Bahn einzugraben, darin besteht diese letztere anodisch zu oxidieren.

## Claims

1. Process for electrical connection of transistor chips mounted on an integrated circuit board (10), comprising welding the electrodes (26, 28) of the collector, emitter and grid control onto the corresponding chip connection sites (14, 16), at least some of the emitter electrodes (26) are made of one piece in the form of a plate (20) of electrically conductive material comprising on one of its large faces projecting parts delimiting the connection studs which are to be welded to the corresponding connection sites, **characterised in that** the transistor is an isolated grid bipolar resistor and **in that** a grid control electrode (28) is produced by forming in said plate a projecting stud associated with a supply track and isolated from the rest of the plate, the stud being welded to a corresponding connection site.

2. Process according to claim 1, **characterised in that** since the connection sites (14, 16) are covered with a metal layer namely aluminium, it comprises the following steps prior to welding of the emitter electrodes:
- de-oxidation of the electrode connection sites (14, 16);
- deposition of an anti-oxidant material layer on the de-oxidised connection sites;
- deposition of soldering alloy on the connection sites;
- deposition of said plate (20) on the printed circuit boards (10) so as to apply the projecting parts to the connection sites; and
- placing of the plate and board in a melting oven.

3. Process according to claim 2, **characterised in that** the anti-oxidant material is selected from nickel, chromium, gold or an alloy of these materials.

4. Process according to one of claims 2 or 3, **characterised in that** the de-oxidation stage comprises treating the boards (10) with nitric acid.

5. Process according to any of claims 1 to 4, **characterised in that** the grid control electrode (28) is produced during production of the emitter electrodes (26).

6. Process according to claim 5, **characterised in that** since said plate comprises an anodised metal, in particular aluminium, production of the grid control electrode comprises steps of:
- forming by metallisation of an electrically conductive layer (30) covering the anodised surface of the stud forming the grid control electrode;
- forming of the supply track by metallisation of the anodised surface of the plate;
- embedding of the metallised track; and
- deposition on the studs of a layer of anti-oxidant material.

7. Process according to claim 6, **characterised in that** after the step comprising forming of the supply track, on the latter is deposited a metal layer.

8. Process according to one of claims 6 or 7, **characterised in that** the step comprising embedding of the metallised track comprises anodising the latter.
